(19) Europäisches Patentamt / European Patent Office / Office européen des brevets

(11) **EP 3 063 546 B1**

(12) **FASCICULE DE BREVET EUROPEEN**

(45) Date de publication et mention de la délivrance du brevet:
**17.11.2021 Bulletin 2021/46**

(51) Int Cl.:
*G01R 31/11* *(2006.01)*          *H04B 3/46* *(2015.01)*
*H04L 5/00* *(2006.01)*          *G01R 31/28* *(2006.01)*
*G01R 31/08* *(2020.01)*          *H04L 27/26* *(2006.01)*

(21) Numéro de dépôt: **14789803.5**

(22) Date de dépôt: **20.10.2014**

(86) Numéro de dépôt international:
**PCT/EP2014/072394**

(87) Numéro de publication internationale:
**WO 2015/062885 (07.05.2015 Gazette 2015/18)**

(54) **MÉTHODE DE GÉNÉRATION D'UN SIGNAL DE RÉFLECTOMÉTRIE MULTI-PORTEUSES POUR UNE MISE EN OEUVRE DANS UN SYSTÈME DISTRIBUÉ**

VERFAHREN ZUR ERZEUGUNG EINES MEHRTRÄGER-REFLEKTOMETRIESIGNALS ZUR IMPLEMENTIERUNG IN EINEM VERTEILTEN SYSTEM

METHOD FOR GENERATING A MULTI-CARRIER REFLECTOMETRY SIGNAL FOR IMPLEMENTATION IN A DISTRIBUTED SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.10.2013 FR 1360657**

(43) Date de publication de la demande:
**07.09.2016 Bulletin 2016/36**

(73) Titulaire: **Commissariat à l'Énergie Atomique et aux Énergies Alternatives 75015 Paris (FR)**

(72) Inventeurs:
• **BEN HASSEN, Wafa F-75005 Paris (FR)**
• **AUZANNEAU, Fabrice F-91300 Massy (FR)**

(74) Mandataire: **Marks & Clerk France Immeuble "Visium" 22, avenue Aristide Briand 94117 Arcueil Cedex (FR)**

(56) Documents cités:

• **WAFA BEN HASSEN ET AL: "On-line diagnosis using Orthogonal Multi-Tone Time Domain Reflectometry in a lossy cable", SYSTEMS, SIGNALS&DEVICES (SSD), 2013 10TH INTERNATIONAL MULTI-CONFERENCE ON, IEEE, 18 mars 2013 (2013-03-18), pages 1-6, XP032439823, DOI: 10.1109/SSD.2013.6564144 ISBN: 978-1-4673-6459-1**
• **Anonymous: "Window function - Wikipedia, the free encyclopedia", Wikipedia, 19 octobre 2013 (2013-10-19), XP055129219, Extrait de l'Internet: URL:http://en.wikipedia.org/w/index.php?ti tle=Window_function&oldid=577892584 [extrait le 2014-07-16]**
• **WAFA BEN HASSEN ET AL: "OMTDR using BER estimation for ambiguities cancellation in ramified networks diagnosis", INTELLIGENT SENSORS, SENSOR NETWORKS AND INFORMATION PROCESSING, 2013 IEEE EIGHTH INTERNATIONAL CONFERENCE ON, IEEE, 2 avril 2013 (2013-04-02), pages 414-419, XP032422571, DOI: 10.1109/ISSNIP.2013.6529826 ISBN: 978-1-4673-5499-8 cité dans la demande**
• **BEN HASSEN WAFA ET AL: "Diagnosis sensor fusion for wire fault location in CAN bus systems", 2013 IEEE SENSORS, IEEE, 3 novembre 2013 (2013-11-03), pages 1-4, XP032532504, ISSN: 1930-0395, DOI: 10.1109/ICSENS.2013.6688264 [extrait le 2013-12-18]**

EP 3 063 546 B1

**Description**

La présente invention concerne le domaine du diagnostic en ligne de réseaux filaires complexes constitués de câbles ou lignes de transmission de natures diverses, par exemple des câbles électriques, coaxiaux, bifilaires, en lignes parallèles, en paires torsadées en toron de câble ou autre.

L'invention se positionne dans le domaine de la réflectométrie qui consiste, à partir de l'injection d'un ou plusieurs signaux de tests au sein du câble ou réseau de câble à tester, de mesurer le signal réfléchi sous forme d'un réflectogramme et d'en déduire une information sur les discontinuités d'impédances qui sont caractéristiques de défauts électriques. De cette façon il est possible de diagnostiquer un réseau filaire complexe en détectant et localisant des défauts éventuels.

L'invention porte en particulier sur une méthode de génération d'un signal de réflectométrie multi-porteuses pour une mise en œuvre dans un système de réflectométrie distribuée adapté aux réseaux filaires composés de nombreuses branches, telle que décrite dans la revendication 1.

L'invention porte également sur une méthode d'analyse de défauts électriques à partir de l'injection d'un signal de réflectométrie multi-porteuses telle que décrite dans la revendication 5, ainsi qu'un dispositif de réflectométrie tel que décrit dans les revendications 8 et 9 et un système distribué comprenant une pluralité de tels dispositifs tel que décrit dans la revendication 10.

Le principe de la réflectométrie consiste à injecter un signal sur un réseau de câbles puis à mesurer les échos renvoyés suite à la variation brusque de l'impédance caractéristique d'une ou plusieurs lignes de transmissions branchées par des connecteurs formant ainsi des jonctions. Les caractéristiques de ces échos, telles que le retard par rapport au signal de test et l'amplitude, permettent d'obtenir des informations sur la position et le type des défauts électriques présents dans ce réseau.

Dans le cas d'un diagnostic en ligne, le signal de test est envoyé sur le réseau lorsque le système à diagnostiquer est en fonctionnement permettant de se trouver dans les conditions réelles du système, donc d'établir un diagnostic plus poussé tel que la caractérisation de défauts intermittents ou dits transitoires. Cependant, il faut éviter toute interférence entre les signaux liés au fonctionnement du système cible et ceux injectés par le système de réflectométrie. Cela se traduit par diverses contraintes (variables d'une application à l'autre) au niveau de la compatibilité électromagnétique, de l'interférence des signaux entre eux ou encore de la robustesse au bruit.

Ce problème d'interférence s'aggrave dans le cas d'un diagnostic distribué où plusieurs réflectomètres effectuent une mesure de réflectométrie en plusieurs points du réseau cible simultanément. Les différents signaux qui se propagent dans le réseau sont susceptibles d'interférer entre eux et de fausser ainsi les résultats du diagnostic.

Le domaine de la réflectométrie contient plusieurs méthodes qui permettent de répondre, dans certains cas d'applications, à certaines contraintes d'un diagnostic en ligne. On peut citer notamment les méthodes suivantes.

La réflectométrie SSTDR (« Spread Spectrum Time Domain Reflectometry »), comme décrit dans le document référencé [1] est basée sur la réflectométrie STDR (« Sequence Time Domain Reflectometry »). Elle permet de déplacer le spectre du signal émis par le biais de l'application d'une modulation par une fréquence porteuse des séquences binaires pseudo-aléatoires de la réflectométrie STDR. Cependant l'occupation spectrale est deux fois plus importante qu'avec la réflectométrie STDR et le spectre peut juste être décalé mais pas contrôlé entièrement.

La réflectométrie NDR (« Noise Domain Reflectometry »), comme décrit dans le document référencé [2] permet de faire de la réflectométrie sans émettre aucun signal. Ce sont les signaux déjà présents sur la ligne qui sont utilisés. Bien que cette méthode puisse être intéressante dans certains cas, elle présente des inconvénients majeurs : les signaux présents dans le réseau de câbles doivent avoir les propriétés adéquates, les traitements sont plus complexes et les signaux de test ne sont pas périodiques ce qui a des conséquences sur la complexité du traitement et sur la qualité de la mesure.

La réflectométrie MCR (« MultiCarrier Reflectometry »), comme décrit dans le document référencé [3] utilise des signaux multi-porteuses. Son intérêt est la grande flexibilité avec laquelle on peut moduler le spectre du signal émis, ce qui permet ainsi de s'adapter à des contraintes propres au diagnostic en ligne. Par exemple, s'il est interdit d'émettre sur une bande de fréquence située au milieu du spectre du signal test, il est tout à fait possible d'annuler l'énergie du signal sur cette bande de fréquences. La méthode proposée reste cependant très limitée car elle ne permet de diagnostiquer que des lignes de transmission simples et uniformes.

On connait également la réflectométrie MCTDR (« MultiCarrier Time Domain Reflectometry »), comme décrit dans le document référencé [4].

Ces méthodes de l'art connu souffrent d'un manque de flexibilité pour assurer un bon diagnostic en ligne dans le cas d'un réseau de topologie complexe avec la présence de défauts non francs. Sachant que l'occupation spectrale du signal de test est l'un des aspects majeurs pour assurer un bon diagnostic en ligne sur le réseau de câbles, le spectre du signal doit permettre de limiter les interférences avec le fonctionnement de l'application sans dégrader la qualité du réflectogramme obtenu.

Dans le cas d'un réseau filaire complexe, la détection et la localisation d'un ou plusieurs défaut(s) francs ou non francs s'avèrent impossibles avec un seul point d'injection. La réflectométrie distribuée semble être une bonne solution pour remédier à ce problème. On entend par réflectométrie distribuée, l'injection du signal de test en plusieurs points du réseau et la récupération du signal réfléchi en un ou plusieurs points selon la stratégie de diagnostic choisie.

Le document référencé [5] décrit une méthode de réflectométrie, qui consiste à utiliser des séquences pseudo-aléatoires de type séquence M (ou « Maximum Length Sequence ») comme signal de test et à minimiser l'inter-corrélation entre les séquences générées par les différents réflectomètres. Le post-traitement (algorithme de discrimination) consiste ensuite à appliquer un filtrage adapté comme dans la méthode STDR (« Sequence Time Domain Reflectometry»). Les inconvénients majeurs de cette stratégie sont les suivants. D'une part, elle ne permet pas une annulation complète de la contribution des autres réflectomètres. Il reste un bruit résiduel. D'autres part, elle impose l'utilisation d'un signal de type séquence M (ou LFSR, « Logical Feedback Shift Register » à longueur maximum). En effet, dans certains cas d'application, des signaux de test, tels que les signaux multi-porteuses, peuvent être nécessaires du fait des contraintes de l'application considérée.

Le document référencé [6] a proposé comme recours une méthode de moyennes sélectives totalement indépendante du signal de test. L'idée principale est d'insérer des coefficients de pondération à l'émission du signal et à la réception lors du calcul de la moyenne. Le choix de ces coefficients se base sur les séquences de Walsh-Hadamard. Cette méthode permet d'obtenir des niveaux de bruit résiduel négligeables, mais elle s'avère limitée dans le cas d'un réseau complexe puisque le nombre de mesures augmente avec le nombre de réflectomètres dans le réseau d'une façon exponentielle. Dans ce cas, le calcul des moyennes sélectives exige un temps de calcul non négligeable dans le cas de plusieurs réflectomètres, ce qui met en question la capacité de la méthode d'assurer un diagnostic en temps réel, notamment en ce qui concerne des défauts intermittents.

L'invention propose de pallier aux limitations des méthodes de réflectométrie connues par l'utilisation d'un signal de réflectométrie multi-porteuses basée sur la technologie OFDM (Orthogonal Frequency Division Multiplexing) utilisée dans le domaine des communications numériques.

Le document [7] décrit le principe de base de la réflectométrie dite OMTDR (« Orthogonal Multi-Tone Time Domain Reflectometry ») qui consiste à utiliser des porteuses fréquentielles orthogonales entre elles pour éviter les interférences entre réflectomètres connectés à un même réseau filaire.

On connait par ailleurs également le document « On-Line Diagnosis using Orthogonal Multi-Tone Time Domain Reflectometry in a Lossy Cable, Wafa Ben Hassen, Fabrice Auzanneau, Luca Incarbone, François Pérès, Ayeley P.Tchangani » qui concerne également le domaine de la réflectométrie dite OMTDR.

L'invention propose notamment une méthode d'allocation des sous-porteuses d'un signal de réflectométrie OMTDR aux différents dispositifs d'un système de réflectométrie distribué de sorte à limiter les interférences entre signaux et à assurer un diagnostic en ligne de qualité constante quel que soit le dispositif utilisé dans le système.

L'invention a ainsi pour objet une méthode de génération d'un signal de réflectométrie pour le diagnostic de défauts impactant une ligne de transmission ou un réseau de lignes de transmission, ladite méthode étant exécutée par chacun des dispositifs d'une pluralité de dispositifs de diagnostic appartenant à un système distribué comprenant une pluralité de dispositifs de diagnostic connectés à ladite ligne ou audit réseau de lignes, ladite méthode comprenant les étapes suivantes :

- Générer un signal électrique comprenant une pluralité de porteuses fréquentielles réparties à intervalles réguliers dans l'ensemble de la bande de fréquences utile subdivisée en sous-porteuses de sorte que chaque dispositif dudit système distribué utilise des sous-porteuses différentes des autres dispositifs dudit système,
- Injecter ledit signal électrique dans ladite ligne ou réseau de lignes.

Selon un aspect particulier de l'invention, les sous-porteuses sont orthogonales entre elles.

Selon un aspect particulier de l'invention, au moins une sous-porteuse n'est utilisée par aucun desdits dispositifs de diagnostic dudit système distribué.

Selon un aspect particulier de l'invention, au moins une sous-porteuse est réservée à la communication entre au moins deux dispositifs de diagnostic dudit système distribué.

L'invention a également pour objet une méthode d'analyse de défauts impactant une ligne de transmission ou un réseau de lignes de transmission, ladite méthode étant exécutée par chacun des dispositifs d'une pluralité de dispositifs de diagnostic appartenant à un système distribué comprenant une pluralité de dispositifs de diagnostic connectés à ladite ligne ou audit réseau de lignes, ladite méthode comprenant les étapes suivantes :

- Générer un signal électrique comprenant une pluralité de porteuses fréquentielles réparties à intervalles réguliers dans l'ensemble de la bande de fréquences utile subdivisée en sous-porteuses de sorte que chaque dispositif dudit système distribué utilise des sous-porteuses différentes des autres dispositifs dudit système,
- Injecter ledit signal électrique dans ladite ligne ou réseau de lignes,
- Analyser l'écho dudit signal électrique réfléchi pour en déduire une information relative à la détection et/ou la localisation de discontinuités d'impédance caractéristique d'au moins un défaut.

Selon un aspect particulier de la méthode d'analyse de défauts selon l'invention, l'étape d'analyse de l'écho dudit signal électrique réfléchi comprend au moins les sous-étapes suivantes :

- L'inter-corrélation du signal réfléchi avec le signal injecté pour obtenir un premier réflectogramme,
- La convolution du premier réflectogramme avec une fenêtre d'apodisation pour obtenir un second réflectogramme,
- L'identification de pics d'amplitude dans ledit second réflectogramme.

Selon un aspect particulier de la méthode d'analyse de défauts selon l'invention, la fenêtre d'apodisation est une fenêtre de Dolph-Chebyshev.

L'invention a également pour objet un dispositif de génération d'un signal de réflectométrie pour le diagnostic de défauts impactant une ligne de transmission ou un réseau de lignes de transmission, ledit dispositif comprenant des moyens adaptés pour mettre en œuvre la méthode de génération d'un signal de réflectométrie selon l'invention.

Selon une variante de réalisation, ledit dispositif selon l'invention comprend des moyens adaptés pour mettre en œuvre la méthode d'analyse de défauts selon l'invention.

L'invention a encore pour objet un système distribué pour le diagnostic de défauts impactant une ligne de transmission ou un réseau de lignes de transmission, ledit système comprenant une pluralité de dispositifs d'analyse de défauts selon l'invention connectés à ladite ligne ou audit réseau de lignes.

D'autres caractéristiques et avantages de la présente invention apparaîtront mieux à la lecture de la description qui suit en relation aux dessins annexés qui représentent :

- La figure 1, un synoptique d'un dispositif de génération d'un signal de réflectométrie multi-porteuses orthogonales,
- La figure 2, un diagramme illustrant le spectre fréquentiel d'un signal généré par un dispositif selon la figure 1,
- La figure 3, un synoptique d'un dispositif d'analyse d'un signal de réflectométrie multi-porteuses orthogonales,
- Les figures 4a et 4b, deux diagrammes illustrant le principe, selon l'invention, d'allocation distribuée des sous-porteuses d'un signal de réflectométrie multi-porteuses orthogonales,
- La figure 5, un synoptique d'un système distribué de réflectométrie pour le diagnostic de défauts électriques,
- Les figures 6a,6b,6c, trois réflectogrammes illustrant l'apport de l'invention vis-à-vis d'une méthode d'allocation de sous-porteuses usuelle.

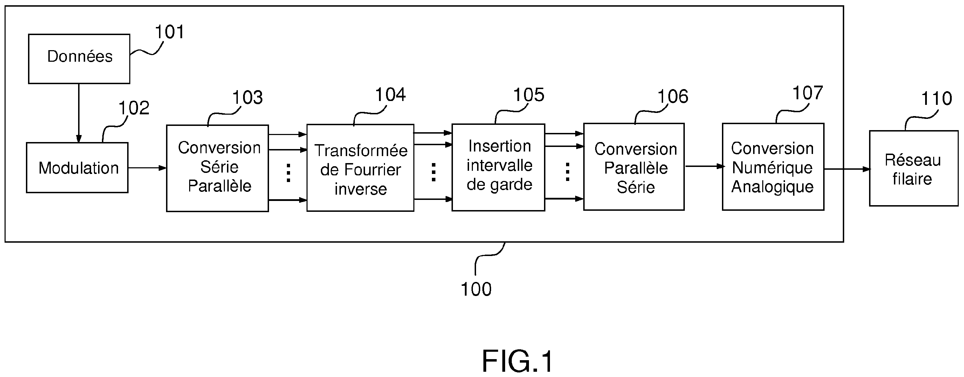

La figure 1 représente, sur un synoptique, un dispositif 100 de génération d'un signal de réflectométrie selon l'invention.

Il comprend notamment un module de génération de données numériques 101 qui peuvent être aléatoires ou véhiculer un message d'information. Ces données peuvent être formatées sous forme de trames comprenant différents champs. Une trame peut notamment contenir un préambule qui permet de synchroniser le signal, un identifiant de début de trame, un identifiant du dispositif source qui a généré le signal, un identifiant d'un dispositif destination du signal au sein d'un système distribué comprenant plusieurs dispositifs. Une trame peut également contenir un champ permettant de déduire la longueur des données transmises dans une trame, une section contenant les données elle mêmes, un champ CRC de contrôle de la redondance cyclique permettant de détecter d'éventuelles erreurs dans la trame et un identifiant de fin de trame.

Le module de génération de données numériques 101 peut également générer un train de bits sans format a priori ou selon un format autre que celui décrit ci-dessus.

Le dispositif 100 comprend également un modulateur 102 qui permet de représenter le train binaire généré sous la forme d'un ensemble de symboles complexes modulés. La modulation employée peut être une modulation d'amplitude en quadrature à M états, M étant un entier supérieur à 2, une modulation de phase ou toute autre modulation.

Le dispositif 100 comprend également un module 103 de conversion série-parallèle qui permet de multiplexer le signal modulé en une pluralité de canaux qui sont ensuite fournis à un module de calcul de la transformée de Fourier inverse 104 du signal afin d'effectuer une conversion dans le domaine fréquentiel. Ainsi, il est possible de transmettre simultanément un ensemble des symboles complexes sur une pluralité de fréquences.

Une sous-porteuse fréquentielle d'indice n peut être décrite par la fonction $g_n(t)$ suivante : $g_n(t) = e^{j2\pi\Delta ft}$ pour t appartenant à l'intervalle temporel $[0, T_s]$ et $g_n(t) = 0$ en dehors de cet intervalle.

Pour garantir l'orthogonalité entre les sous-porteuses, la différence fréquentielle entre deux sous-porteuses adjacentes doit être au moins égale à $\Delta f = 1/T_S$.

Un module 105 d'insertion d'un intervalle de garde temporel de durée $T_G$ permet d'éviter que les symboles interfèrent entre eux. Chaque symbole est ainsi précédé d'une extension périodique du signal lui-même. La durée totale du symbole transmis est $T = T_S + T_G$.

Le dispositif 100 comprend enfin un module 106 de conversion parallèle-série pour démultiplexer le signal multi-porteuses puis un module 107 de conversion numérique-analogique afin de générer un signal analogique de réflectométrie multi-porteuses prêt à être injecté dans un réseau filaire 110.

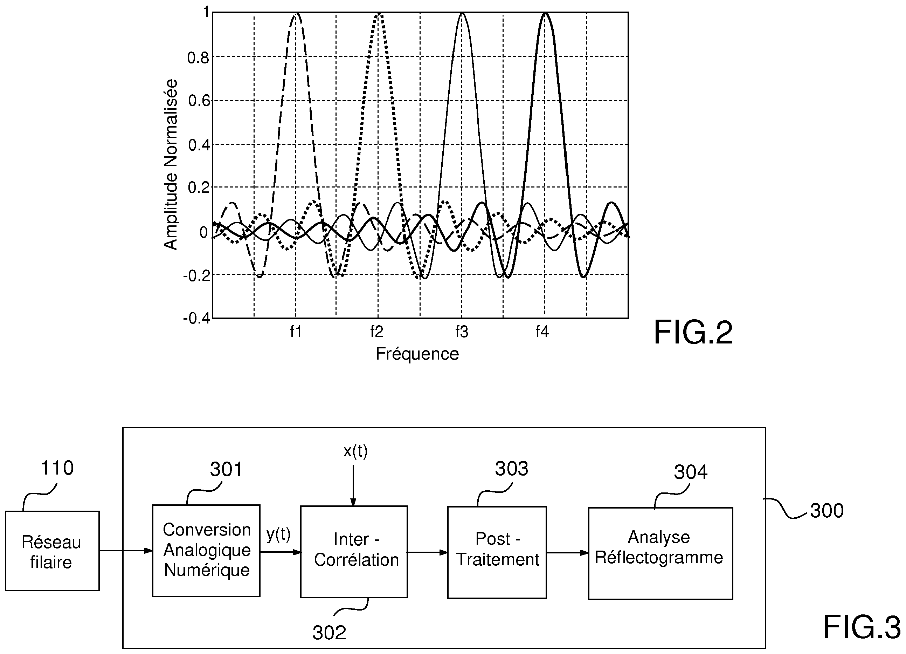

La figure 2 représente, sur un diagramme fréquentiel, l'allure du spectre du signal multi-porteuses obtenu à la suite des étapes décrites à la figure 1 pour un cas particulier où le nombre de sous-porteuses est égal à 4.

La figure 3 représente, sur un synoptique, un dispositif 300 d'analyse du signal de réflectométrie injecté par un dispositif 100 selon la figure 1 dans un réseau filaire.

Un tel dispositif 300 mesure les échos du signal de réflectométrie multi-porteuses injecté dans le réseau filaire 110. Un module de conversion analogique numérique 301 permet de numériser le signal mesuré y(t) qui est ensuite fourni à un module d'intercorrélation 302 qui réalise l'inter-corrélation entre le signal mesuré y(t) et le signal de test injecté x(t) pour obtenir un réflectogramme temporel. Le signal de test injecté x(t) peut être obtenu de différentes façons. Tout d'abord, le dispositif 100 de génération du signal de réflectométrie et le dispositif 300 d'analyse du signal réfléchi peuvent être implémentés selon un seul et même équipement, auquel cas le signal de test x(t) est communiqué directement au module d'intercorrélation 302 sous forme numérique. Si les deux dispositifs 100,300 sont distincts, une entité centrale (non représentée) peut fournir aux deux dispositifs les informations nécessaires pour qu'ils puissent générer localement le même signal de test. Une autre solution, permettant d'éviter l'utilisation d'un équipement supplémentaire, est de sauvegarder en mémoire dans chaque dispositif 100,300, l'ensemble des signaux de test qu'il est envisagé d'utiliser. Chaque dispositif 300 d'analyse peut ensuite être programmé pour associer au signal mesuré le signal de test à utiliser en fonction de l'identifiant du dispositif 100 qui a généré et transmis le signal de réflectométrie reçu.

Un module de post-traitement 303 peut être utilisé pour éliminer les lobes secondaires présents autour de chaque pic du réflectogramme. Ce module peut consister en l'application d'une fenêtre d'apodisation, par exemple une fenêtre de Dolph-Chebyshev. Autrement dit, le réflectogramme obtenu après l'étape d'inter-corrélation 302 est convolué avec une fenêtre temporelle obtenue, par exemple à l'aide de la relation suivante :

$$\omega(i) = TF^{-1}\left[\frac{\cos\left(N\cos^{-1}\left(\beta\cos\left(\frac{\pi i}{N}\right)\right)\right)}{\cos\left(N\cosh^{-1}(\beta)\right)}\right]$$

β est une constante d'ondulation de la bande d'arrêt et est définie par la relation β=cosh(cosh⁻¹(10)/N) avec N le nombre d'échantillons utilisés pour réaliser la fenêtre ω, cosh() désignant la fonction cosinus hyperbolique et cosh⁻¹() sa fonction inverse.

L'objectif de la convolution du réflectogramme avec une fenêtre d'apodisation, par exemple une fenêtre de Dolph-Chebyshev est de réduire les lobes secondaires autour des pics d'intérêt du réflectogramme, lesdits lobes secondaires pouvant être confondus avec des pics résultants de défauts non francs.

D'autres fenêtres équivalentes sont également envisageables.

Un module 304 d'analyse permet enfin d'identifier les pics d'amplitude dans le réflectogramme associés à des discontinuités d'impédance présentes dans le réseau de câbles testé afin de détecter les défauts associés et/ou de les localiser.

Dans le cadre d'un système de réflectométrie distribuée comportant une pluralité de dispositifs de réflectométrie connectés au réseau de câbles à tester et dans lequel chaque dispositif connecté peut générer un signal de réflectométrie multi-porteuses tel que décrit ci-dessus à l'appui des figures 1 et 2, le problème se pose de l'interférence entre les différents signaux de réflectométrie générés.

Pour résoudre ce problème, l'emploi d'un signal comprenant une pluralité de porteuses orthogonales entre elles permet, en allouant une partie des porteuses disponibles à chaque dispositif du système distribué, d'éviter les phénomènes de collision entre deux signaux de réflectométrie générés par deux dispositifs distincts et qui occuperaient des bandes de fréquences identiques ou qui se superposent partiellement.

Pour allouer les différentes porteuses fréquentielles disponibles dans la bande de fréquence considérée aux différents dispositifs du système, la solution immédiate consiste à diviser la bande de fréquence en plusieurs sous-bandes adjacentes chacune allouée à un dispositif.

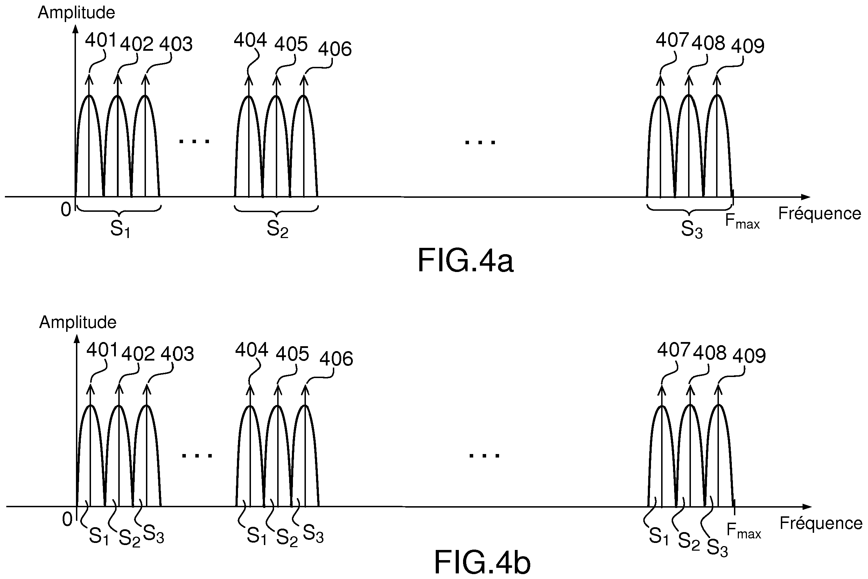

La figure 4a représente sur un diagramme amplitude-fréquence, le spectre d'un signal multi-porteuses dont les sous-porteuses sont réparties entre trois dispositifs de réflectométrie S1,S2,S3 selon cette première solution. En prenant les sous-porteuses dans l'ordre croissant des valeurs de leurs fréquences centrales, un premier groupe de sous-porteuses 401,402,403 adjacentes (3 sous-porteuses dans l'exemple de la figure 4a) sont allouées à un premier dispositif S1. Un second groupe de sous-porteuses adjacentes 404,405,406 de fréquences centrales de valeurs supérieures à celles du premier groupe sont allouées à un deuxième dispositif S2. Enfin, un troisième groupe de sous porteuses 407,408,409 adjacentes situées à l'extrémité opposée de la bande de fréquence du signal sont allouées à un troisième dispositif S3.

Cette solution d'allocation de sous-porteuses dans l'ordre croissant des valeurs de leurs fréquences centrales présentent des inconvénients. En effet, dans le scénario de la figure 4a, la premier dispositif S1 utilise des sous-porteuses situées sensiblement dans les basses fréquences, le deuxième dispositif S2 utilise des sous-porteuses situées dans les moyennes fréquences alors que le troisième dispositif S3 utilise des sous-porteuses situées dans les hautes fréquences. Cette différence d'utilisation du spectre entraine une différence de perspective du réseau vu par les différents dispositifs S1,S2,S3 de réflectométrie. En effet, les réflectogrammes obtenus in fine peuvent différer lorsque les signaux utilisés présentent des occupations spectrales très éloignées en fréquence. En particulier, l'utilisation de sous-porteuses éloignées en fréquence de la composante continue peut engendrer des artefacts dans le réflectogramme mesuré. En outre l'atténuation du signal lors de sa propagation dans le réseau de câbles sous test dépend également de la fréquence du signal. En effet, l'atténuation est plus élevée pour les hautes fréquences que pour les basses fréquences. Pour toutes ces raisons, la solution consistant à allouer la bande de fréquences du signal de réflectométrie multi-porteuses aux différents dispositifs d'un système distribué dans l'ordre croissant des fréquences n'est pas une solution performante.

L'invention propose afin de résoudre les problèmes évoqués ci-dessus, d'allouer les sous-porteuses du signal de test de façon distribuée tel que représenté à la figure 4b.

Les sous-porteuses sont allouées aux différents dispositifs de sorte qu'un dispositif utilise des fréquences régulièrement réparties dans la bande et que tous les dispositifs utilisent des signaux de test fonctionnant à des fréquences proches. Autrement dit, les fréquences allouées à un dispositif sont réparties par intervalles réguliers dans l'ensemble de la bande de fréquence de sorte que chaque signal injecté par chaque dispositif présente un profil spectral le plus proche possible tout en respectant le fait que chaque dispositif utilise des fréquences différentes des autres dispositifs du même système.

Dans l'exemple de la figure 4b, les sous-porteuses sont alternativement allouées à l'un des trois dispositifs S1 ,S2,S3 de sorte que les sous-porteuses 401,404,407 sont allouées au premier dispositif S1, les sous-porteuses 402,405,408 sont allouées au deuxième dispositif S2, les sous-porteuses 403,406,409 sont allouées au troisième dispositif S3.

En procédant de cette façon, on s'assure que chaque dispositif de réflectométrie S1,S2,S3 va générer un signal multi-porteuses utilisant des fréquences régulièrement réparties dans la bande utile. Tous les signaux générés présentent alors un profil spectral proche ce qui permet d'éviter les différences de perspective du réseau filaire et ce qui assure d'obtenir des réflectogrammes homogènes.

Pour générer un signal multi-porteuses comprenant des sous-porteuses non adjacentes, une solution consiste à annuler les symboles correspondants aux sous-canaux que l'on souhaite supprimer dans le signal. Autrement dit, en sortie du module de transformée de Fourier inverse 104, on annule les symboles des sorties dont l'indice correspond au numéro de la sous-porteuse à annuler dans la bande utile du signal.

Comme indiqué sur l'exemple de la figure 4b, toutes les sous-porteuses de la bande utile du signal ne sont pas forcément allouées à un dispositif de réflectométrie pour générer un signal de test en vue de l'analyse des défauts électriques du réseau. Certaines sous-porteuses peuvent être réservées ou interdites car elles correspondent à des plages de fréquences de signaux utiles au fonctionnement du réseau de câbles que l'on souhaite tester. Afin de ne pas perturber le fonctionnement du réseau, aucun signal parasite ne doit être émis dans ces plages interdites. L'orthogonalité des sous-porteuses assure que les signaux utiles du réseau de câbles ne sont effectivement pas perturbés par les signaux de réflectométrie injectés.

D'autres sous-porteuses peuvent être réservées à d'autres fins que l'obtention d'un réflectogramme et notamment peuvent être allouées à la communication entre deux ou plus dispositifs du système distribué dans le but d'échanger des informations via les données éventuellement transportées par le signal.

Il convient de noter également que le principe d'allocation distribuée décrit à la figure 4b peut s'appliquer à l'identique pour un signal multi-porteuses dont les sous-porteuses ne sont pas orthogonales entre elles. Dans un tel cas, on utilise des porteuses suffisamment espacées entre elles pour ne pas générer d'interférences.

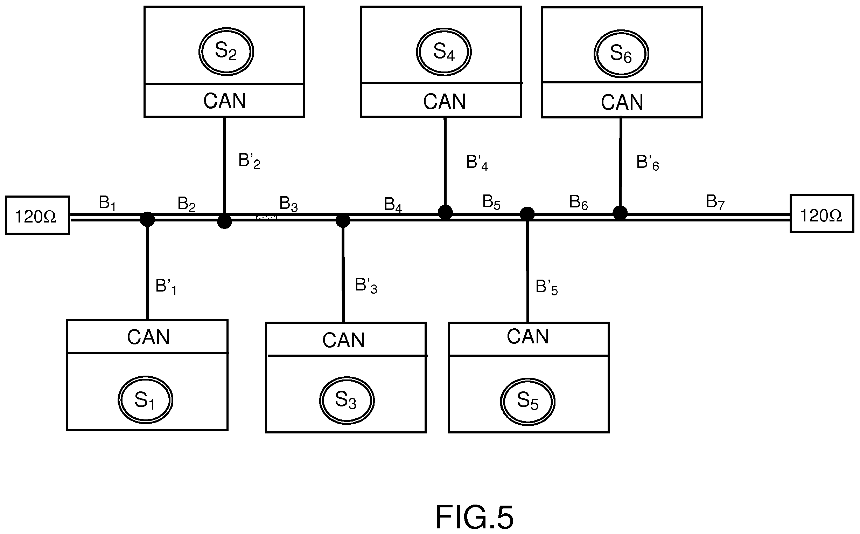

La figure 5 schématise un exemple de système de réflectométrie distribuée selon l'invention comprenant six dispositifs de réflectométrie S1,S2,S3,S4,S5,S6 connectés à un réseau schématisé par une ligne de transmission 500. Chaque dispositif peut générer et injecter un signal de réflectométrie multi-porteuses dans la ligne 500. Chaque dispositif peut également mesurer un écho du signal réfléchi pour démoduler les données comprises dans ce signal et/ou générer un réflectogramme pour analyser les pics d'amplitude qu'il contient et en déduire la présence et la position de défauts électriques sur la ligne 500.

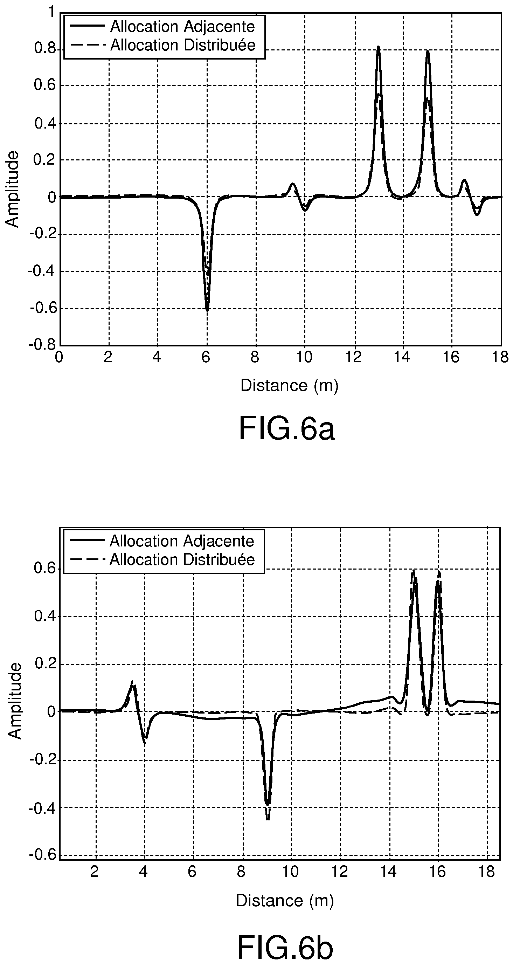

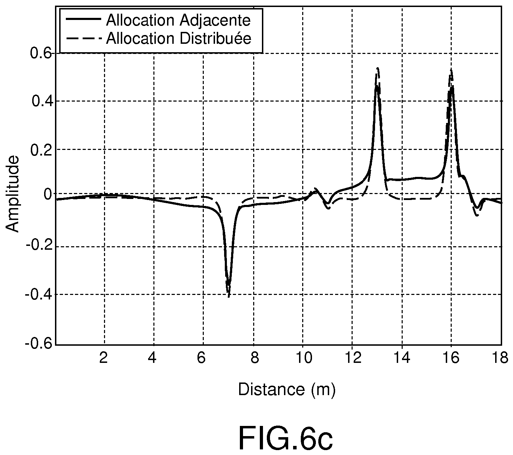

Les figures 6a,6b,6c représentent, sur trois diagrammes amplitude-distance, les réflectogrammes obtenus par trois dispositifs S1,S2,S3 respectivement dans le cas où l'allocation des sous-porteuses du signal de réflectométrie est réalisée de la façon décrite à la figure 4a (allocation dite adjacente) et dans le cas où l'allocation des sous-porteuses du signal de réflectométrie est réalisée de la façon décrite à la figure 4b (allocation dite distribuée).

On remarque que la qualité du diagnostic obtenu pour les trois réflectomètres dans le cas d'une allocation distribuée est meilleure que celle obtenue dans le cas d'une allocation adjacente. En particulier, dans le cas d'une allocation adjacente, les réflectogrammes obtenus par les dispositifs S2 et S3 qui utilisent des fréquences moyennes ou hautes présentent des artefacts qui sont éliminés dans le cas d'une allocation distribuée.

L'invention peut être implémentée sous la forme d'éléments matériel et/ou logiciel. Elle peut être mise en œuvre par un dispositif comprenant un processeur et une mémoire. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gâte Array »).

[1] "Analysis of Spread Spectrum Time Domain Reflectometry for Wire Fault Location" de P. Smith, C. Furse, et J. Gunther. (Sensors Journal, IEEE, 5(6), pages 1469-1478, Décembre 2005).
[2] "Noise Domain Reflectometry for Locating Wiring Faults" de Chet Lo et C. Furse. (Electromagnetic Compatibility, IEEE Transactions on, 47(1), pages 97-104, Février 2005).
[3] "Multicarrier Reflectometry" de S. Naik, CM. Furse, et B. Farhang-Boroujeny. (Sensors Journal, IEEE, 6(3), pages 812-818, Juin 2006).
[4] "On Line Wire Diagnosis using Multicarrier Time Domain Reflectometry for Fault Location" de A. Lelong et M. Olivas. (Sensors Conference, IEEE, pages 751-754, Octobre 2009).
[5] "Distributed Reflectometry-based Diagnosis for Complex Wired Networks" de N. Ravot, F. Auzanneau, Y. Bonhomme, M.O. Carrion, et F. Bouillault. (EMC:Safety, Reliability and Security of Communication and Transportation Syst, EMC Workshop, Paris, Juin 2007).
[6] "Distributed Reflectometry Method for Wire Fault Location Using Selective Average" de A. Lelong, L. Sommervogel, N. Ravot, and M. Olivas. (Sensors Journal, IEEE, 10(2), pages 300-310, Février 2010).
[7] "OMTDR using BER estimation for ambiguities cancellation in ramified networks diagnosis", W. Ben Hassen, F. Auzanneau, L. Incarbone, F. Pérès, Ayeley P.Tchangani, IEEE, 2013

**Revendications**

1. Méthode de génération d'un signal de réflectométrie pour le diagnostic de défauts impactant une ligne de transmission ou un réseau de lignes de transmission (110), ladite méthode étant exécutée par chacun des dispositifs d'une pluralité de dispositifs de diagnostic (100) appartenant à un système distribué comprenant une pluralité de dispositifs de diagnostic ($S_1$, ..., $S_6$) connectés à ladite ligne ou audit réseau de lignes (110), ladite méthode comprenant les étapes suivantes :

• Générer un signal électrique comprenant une pluralité de porteuses fréquentielles réparties à intervalles réguliers dans l'ensemble de la bande de fréquences utile subdivisée en sous-porteuses de sorte que chaque dispositif dudit système distribué utilise des sous-porteuses différentes des autres dispositifs dudit système,
• Injecter ledit signal électrique dans ladite ligne ou réseau de lignes.

2. Méthode de génération d'un signal de réflectométrie selon la revendication 1 dans laquelle les sous-porteuses sont orthogonales entre elles.

3. Méthode de génération d'un signal de réflectométrie selon l'une des revendications 1 ou 2 dans laquelle au moins une sous-porteuse n'est utilisée par aucun desdits dispositifs de diagnostic dudit système distribué.

4. Méthode de génération d'un signal de réflectométrie selon l'une des revendications précédentes dans laquelle au moins une sous-porteuse est réservée à la communication entre au moins deux dispositifs de diagnostic dudit système distribué.

5. Méthode d'analyse de défauts impactant une ligne de transmission ou un réseau de lignes de transmission (110), ladite méthode étant exécutée par chacun des dispositifs d'une pluralité de dispositifs de diagnostic (100) appartenant à un système distribué comprenant une pluralité de dispositifs de diagnostic ($S_1$, ..., $S_6$) connectés à ladite ligne ou audit réseau de lignes (110), ladite méthode comprenant les étapes suivantes :

• Générer un signal électrique comprenant une pluralité de porteuses fréquentielles réparties à intervalles réguliers dans l'ensemble de la bande de fréquences utile subdivisée en sous-porteuses de sorte que chaque dispositif dudit système distribué utilise des sous-porteuses différentes des autres dispositifs dudit système,
• Injecter ledit signal électrique dans ladite ligne ou réseau de lignes,
• Analyser l'écho dudit signal électrique réfléchi pour en déduire une information relative à la détection et/ou la localisation de discontinuités d'impédance caractéristique d'au moins un défaut.

6. Méthode d'analyse de défauts selon la revendication 5 dans laquelle l'étape d'analyse de l'écho dudit signal électrique réfléchi comprend au moins les sous-étapes suivantes :

• L'inter-corrélation (302) du signal réfléchi avec le signal injecté pour obtenir un premier réflectogramme,
• La convolution (303) du premier réflectogramme avec une fenêtre d'apodisation pour obtenir un second réflectogramme,
• L'identification (304) de pics d'amplitude dans ledit second réflectogramme.

7. Méthode d'analyse de défauts selon la revendication 6 dans laquelle la fenêtre d'apodisation est une fenêtre de Dolph-Chebyshev.

8. Dispositif (100) de génération d'un signal de réflectométrie pour le diagnostic de défauts impactant une ligne de transmission ou un réseau de lignes de transmission, ledit dispositif comprenant des moyens adaptés pour mettre en œuvre la méthode de génération d'un signal de réflectométrie selon l'une quelconque des revendications 1 à 4.

9. Dispositif (100,300) d'analyse de défauts impactant une ligne de transmission ou un réseau de lignes de transmission, ledit dispositif comprenant des moyens adaptés pour mettre en œuvre la méthode d'analyse de défauts selon l'une des revendications 5 à 7.

10. Système distribué pour le diagnostic de défauts impactant une ligne de transmission ou un réseau de lignes de transmission, ledit système comprenant une pluralité de dispositifs d'analyse de défauts selon la revendication 9 connectés à ladite ligne ou audit réseau de lignes.

**Patentansprüche**

1. Verfahren zum Erzeugen eines Reflektometriesignals für die Diagnose von Fehlern, die eine Übertragungsleitung oder ein Netzwerk von Übertragungsleitungen (110) betreffen, wobei das Verfahren von jedem der Geräte einer Vielzahl von Diagnosegeräten (100) durchgeführt wird, die zu einem verteilten System gehören, das eine Vielzahl von Diagnosegeräten ($S_1$, ..., $S_6$) umfasst, die mit der Leitung oder dem Netzwerk von Leitungen (110) verbunden sind, wobei das Verfahren die folgenden Schritte umfasst:

   • Erzeugen eines elektrischen Signals, das eine Vielzahl von Frequenzträgern umfasst, die in regelmäßigen Abständen über das gesamte Nutzfrequenzband verteilt und in Subträger unterteilt sind, so dass jedes Gerät des verteilten Systems andere Subträger als die anderen Geräte des Systems verwendet,
   • Einspeisen des elektrischen Signals in die Leitung oder das Netzwerk von Leitungen.

2. Verfahren zum Erzeugen eines Reflektometriesignals nach Anspruch 1, wobei die Subträger orthogonal zueinander sind.

3. Verfahren zum Erzeugen eines Reflektometriesignals nach einem der Ansprüche 1 oder 2, wobei mindestens ein Subträger von keinem der Diagnosegeräte des verteilten Systems verwendet wird.

4. Verfahren zum Erzeugen eines Reflektometriesignals nach einem der vorhergehenden Ansprüche, wobei mindestens ein Subträger für die Kommunikation zwischen mindestens zwei Diagnosegeräten des verteilten Systems reserviert ist.

5. Verfahren zum Analysieren von Fehlern, die eine Übertragungsleitung oder ein Netzwerk von Übertragungsleitungen (110) betreffen, wobei das Verfahren von jedem der Geräte einer Vielzahl von Diagnosegeräten (100) durchgeführt wird, die zu einem verteilten System gehören, das eine Vielzahl von Diagnosegeräten ($S_1$, ..., $S_6$) umfasst, die mit der Leitung oder dem Netzwerk von Leitungen (110) verbunden sind, wobei das Verfahren die folgenden Schritte umfasst:

   • Erzeugen eines elektrischen Signals, das eine Vielzahl von Frequenzträgern umfasst, die in regelmäßigen Abständen über das gesamte Nutzfrequenzband verteilt und in Subträger unterteilt sind, so dass jedes Gerät des verteilten Systems andere Subträger als die anderen Geräte des Systems verwendet,
   • Einspeisen des elektrischen Signals in die Leitung oder das Netzwerk von Leitungen,
   • Analysieren des Echos des reflektierten elektrischen Signals, um daraus eine Information über die Erkennung und/oder Lokalisierung von Impedanzdiskontinuitäten abzuleiten, die für mindestens einen Fehler charakteristisch sind.

6. Verfahren zum Analysieren von Fehlern nach Anspruch 5, wobei der Schritt des Analysierens des Echos des reflektierten elektrischen Signals mindestens die folgenden Teilschritte umfasst:

   • Interkorrelieren (302) des reflektierten Signals mit dem eingespeisten Signal, um ein erstes Reflektogramm zu erhalten,
   • Falten (303) des ersten Reflektogramms mit einem Apodisationsfenster, um ein zweites Reflektogramm zu erhalten,
   • Identifizieren (304) von Amplitudenspitzen im zweiten Reflektogramm.

7. Verfahren zum Analysieren von Fehlern nach Anspruch 6, wobei das Apodisationsfenster ein Dolph-Tschebyscheff-Fenster ist.

8. Gerät (100) zum Erzeugen eines Reflektometriesignals für die Diagnose von Fehlern, die eine Übertragungsleitung oder ein Netzwerk von Übertragungsleitungen betreffen, wobei das Gerät Mittel umfasst, die zum Durchführen des Verfahrens zum Erzeugen eines Reflektometriesignals nach einem der Ansprüche 1 bis 4 ausgelegt sind.

9. Gerät (100, 300) zum Analysieren von Fehlern, die sich auf eine Übertragungsleitung oder ein Netzwerk von Übertragungsleitungen auswirken, wobei das Gerät Mittel umfasst, die zum Durchführen des Fehleranalyseverfahrens nach einem der Ansprüche 5 bis 7 ausgelegt sind.

10. Verteiltes System für die Diagnose von Fehlern, die sich auf eine Übertragungsleitung oder ein Netzwerk von Übertragungsleitungen auswirken, wobei das System eine Vielzahl von Fehleranalysegeräten nach Anspruch 9 umfasst, die mit der Leitung oder dem Netzwerk von Leitungen verbunden sind.

## Claims

1. A method for generating a reflectometry signal for the diagnosis of defects impacting a transmission line or a network of transmission lines (110), said method being executed by each of the devices of a plurality of diagnosis devices (100) belonging to a distributed system comprising a plurality of diagnosis devices ($S_1$,..., $S_6$) connected to said line or to said network of lines (110), said method comprising the following steps:

   • generating an electrical signal comprising a plurality of frequency carriers dispersed at regular intervals over the whole of the useful frequency band subdivided into sub-carriers so that each device of said distributed system uses different sub-carriers from the other devices of said system,
   • injecting said electrical signal into said line or network of lines.

2. The method for generating a reflectometry signal according to claim 1, wherein the sub-carriers are orthogonal to one another.

3. The method for generating a reflectometry signal according to one of claims 1 or 2, wherein at least one sub-carrier is not used by any of said diagnosis devices of said distributed system.

4. The method for generating a reflectometry signal according to one of the preceding claims, wherein at least one sub-carrier is reserved for the communication between at least two diagnosis devices of said distributed system.

5. A method for analysing defects impacting a transmission line or a network of transmission lines (110), said method being executed by each of the devices of a plurality of diagnosis devices (100) belonging to a distributed system comprising a plurality of diagnosis devices ($S_1$,..., $S_6$) connected to said line or to said network of lines (110), said method comprising the following steps:

   • generating an electrical signal comprising a plurality of frequency carriers dispersed at regular intervals over the whole of the useful frequency band subdivided into sub-carriers so that each device of said distributed system uses different sub-carriers from the other devices of said system,
   • injecting said electrical signal into said line or network of lines,
   • analysing the echo of said reflected electrical signal to deduce therefrom a piece of information relating to the detection and/or the location of discontinuities of impedance characteristic of at least one defect.

6. The method for analysing defects according to claim 5, wherein the step of analysing the echo of said reflected electrical signal comprises at least the following substeps:

   • the inter-correlation (302) of the reflected signal with the injected signal to obtain a first reflectogram,
   • the convolution (303) of the first reflectogram with an apodization window to obtain a second reflectogram,
   • the identification (304) of amplitude spikes in said second reflectogram.

7. The method for analysing defects according to claim 6, wherein the apodization window is a Dolph-Chebyshev window.

8. A device (100) for generating a reflectometry signal for the diagnosis of defects impacting a transmission line or a network of transmission lines, said device comprising means suitable for implementing the method for generating a reflectometry signal according to any one of claims 1 to 4.

9. A device (100, 300) for analysing defects impacting a transmission line or a network of transmission lines, said device comprising means suitable for implementing the method for analysing defects according to one of claims 5 to 7.

10. A distributed system for the diagnosis of defects impacting a transmission line or a network of transmission lines, said system comprising a plurality of devices for analysing defects according to claim 9, connected to said line or to said network of lines.

FIG.1

EP 3 063 546 B1

FIG.2

FIG.3

FIG.4a

FIG.4b

EP 3 063 546 B1

FIG.5

FIG.6a

FIG.6b

FIG.6c

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Analysis of Spread Spectrum Time Domain Reflectometry for Wire Fault Location. **P. SMITH ; C. FURSE ; J. GUNTHER.** Sensors Journal. IEEE, Décembre 2005, vol. 5, 1469-1478
- **CHET LO ; C. FURSE.** Noise Domain Reflectometry for Locating Wiring Faults. *Electromagnetic Compatibility, IEEE Transactions on,* Février 2005, vol. 47 (1), 97-104
- Multicarrier Reflectometry. **S. NAIK ; CM. FURSE ; B. FARHANG-BOROUJENY.** Sensors Journal. IEEE, Juin 2006, vol. 6, 812-818
- On Line Wire Diagnosis using Multicarrier Time Domain Reflectometry for Fault Location. **A. LELONG ; M. OLIVAS.** Sensors Conference. IEEE, Octobre 2009, 751-754
- Distributed Reflectometry-based Diagnosis for Complex Wired Networks. **N. RAVOT ; F. AUZANNEAU ; Y. BONHOMME ; M.O. CARRION ; F. BOUILLAULT.** EMC:Safety, Reliability and Security of Communication and Transportation Syst, EMC Workshop. Juin 2007
- Distributed Reflectometry Method for Wire Fault Location Using Selective Average. **A. LELONG ; L. SOMMERVOGEL ; N. RAVOT ; M. OLIVAS.** Sensors Journal. IEEE, Février 2010, vol. 10, 300-310
- **W. BEN HASSEN ; F. AUZANNEAU ; L. INCARBONE ; F. PÉRÈS ; AYELEY P.** OMTDR using BER estimation for ambiguities cancellation in ramified networks diagnosis. IEEE, 2013